# EUROPEAN PATENT APPLICATION

(11) **EP 1 577 801 A1**
(43) Date of publication of application: **21.09.2005**
(21) Application number: 04006074.1
(22) Date of filing: 15.03.2004
(51) Int. Cl.: G06F 17/50

(54) **Device characterization concept**

(71) Applicant: Infineon Technologies AG, 81669 München (DE)
(72) Inventor: Hong, Eric Liau Chee, 80339 München (DE)
(74) Representative: Lippert, Stachow & Partner

(57) **Abstract**

The invention concerns a device characterization concept to test a semiconductor design by simulation, comprising storing an defined pattern and defined pattern analysis length, an analysis time and defined number of characterization design parameters as a list in a memory simulating a device under test (DUT). It is an object of the invention to define a pattern to estimate in a short time if the worst case is meet. The invention is characterized in, that the design parameters are a function of different customer like pattern and test condition according the equation characterize design parameters (randomize/optimize (input pattern, test condition)) by using pattern and condition variation and optimization technique (PCVOT), so that the design parameters are a function of different customer like pattern and test condition and that the range of design parameters variation with respect to the different input pattern or condition or combination of them is analyzed until the worst case is detected.

## Description

The invention concerns a device characterization concept to test a semiconductor design by simulation, comprising storing an defined pattern and defined pattern analysis length, an analysis time and defined number of characterization design parameters as a list in a memory simulating a device under test (DUT).

On developing new semiconductor devices several simulation processes are used to create the circuit respective the layout as well as the several production steps like photolithography and so on. After this procedure it is necessary to check the design if all given parameters or specifications are reached. Such a procedure is also necessary on customer developed circuits which does not run. To determine weakness in design or trends in the manufacturing process is used a general characterization concept to test the design.

A typical way of a characterization concept is done by varying the design (test) parameters (e.g. timing, current, etc.) with respect of pre-defined pattern and test condition, and determinig where the part passes or fails.

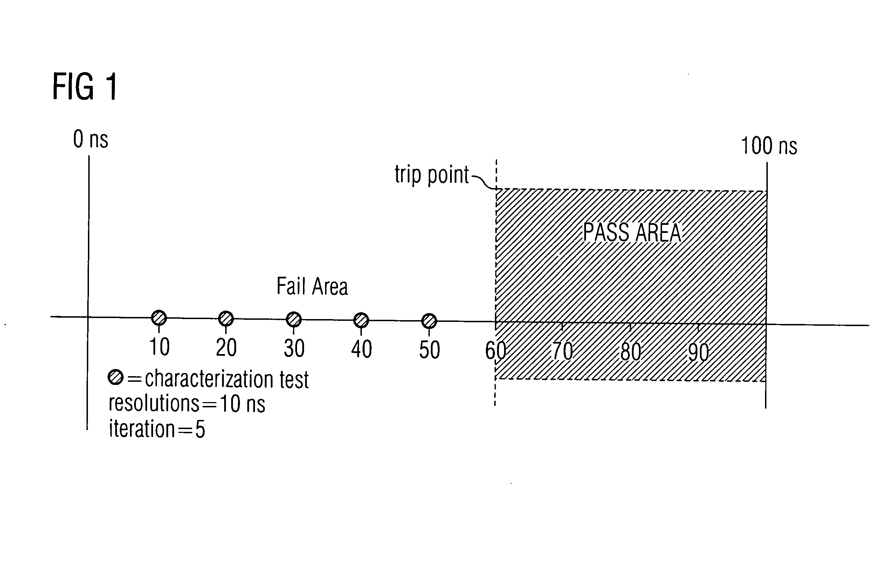

Such a process is general shown in Fig. 1 (prior art) with fail and pass areas. The key to this process is detecting the trip point between the two areas as accurately as possible to ensure that the design meet all specifications. For that the design(test) parameters must be altered. There are known various methods for altering design (test) parameters to find a the trip point of the device, such as linear, binary or successive approximation search methods. It seems to be clear that these method is very time expensive.

But there are many cases shown that several design parameters are measured and passed within the design specifications using typical characterization concept failed to detect the worst case behavior in real customer application site. That means that the customer could still see specification violation during application test. Thereby, the major technical problem and challenge is that what is the weakness in typical characterization concept and how is to overcome this weakness.

It is very difficult to determine if the characterization measurements are closed to the worst case or far from it. This is because typical characterization is done based on only a small set of pre-defined patterns and test conditions and testing it in a very short time. Therefore this process certainly can not represent the potential worst case in real application.

For example, one design parameter value could change due to different access sequence under different condition and run time. Thus, single access using pre-defined pattern can not estimate accurately if the worst case is meet or not. Moreover there is no way to make a wild guess of what is the worst case pattern, such as a very large random pattern (2 million cycles). It can understand that this can only represent a short functional test.

In case that any design parameters failed to detect the worst case could lead to a very heavy effort in design analysis latter, such as trial and error, individual experiences are needed. Moreover it is a very time consuming work to find out where and why does the design parameters fail to meet specification.

The use of a typical characterization concept leads to disadvantages under prior art. So is used a small set of pre-defined pattern and test condition as well as a short run time. Therefore this process can not represent the worst case in real application, since each characterization measurements are input pattern, test condition and run time dependent. Thus, the typical characterization concept can not ensure that the worst case characterization is performed.

It is also to point out that the typical characterization concept can not capture the design parameters variation with respect to different input pattern sequence or test condition or combination of them. Furthermore are very large random customer like pattern not practical for circuit simulation analysis.

Another problem is that many large random patterns can cause a lot of time in test program compiling, loading and executing and need a lot of memory space.

Finally, all characterization results are based on individual test pattern and test condition. Therefore, this method can only represent the very small part of the functional verification, but it does not imply the design will not violate the specification if customer using other access sequence under different condition. This is the major weakness in typical characterization concept.

It is a first object of the invention to define a pattern to estimate in a short time if the worst case is meet.

A second object of the invention is to find out if the design parameters meets the specification within a short time.

A third object of the invention is that the characterization concept captures the design parameters variation with respect to different input pattern sequences or test condition or combination of them.

A fourth object of the invention is to reduce the time in test compiling, loading and executing and to reduce the necessary memory space.

This objections are overcome with the characterizing features of claim 1. Further embodiments of the invention are claimed in the dependent sub claims.

The invention is described on some examples now. In the accompanying drawings are shown:
- Fig. 1:: a trip point detection concept in device characterization (prior art);
- Fig. 2:: a pattern of design parameters variation with predefined test condition;
- Fig. 3:: a pattern of worst case design parameter analysis with pre-defined test condition;
- Fig. 4:: a pattern of design parameters variation analysis with random test condition;
- Fig. 5:: a pattern of worst case design parameter analysis with random test condition;
- Fig. 6:: a general scheme of the multiple trip point concept in device characterization process; and
- Fig. 7:: an experimental result demonstrating the excellent overview of design parameter variation range.

To ensure the worst case design parameters characterization is to prepare a list of priority one design parameters according the customer requirements first. The list of design parameters is then analyzed systematically using the four variations of the invention.

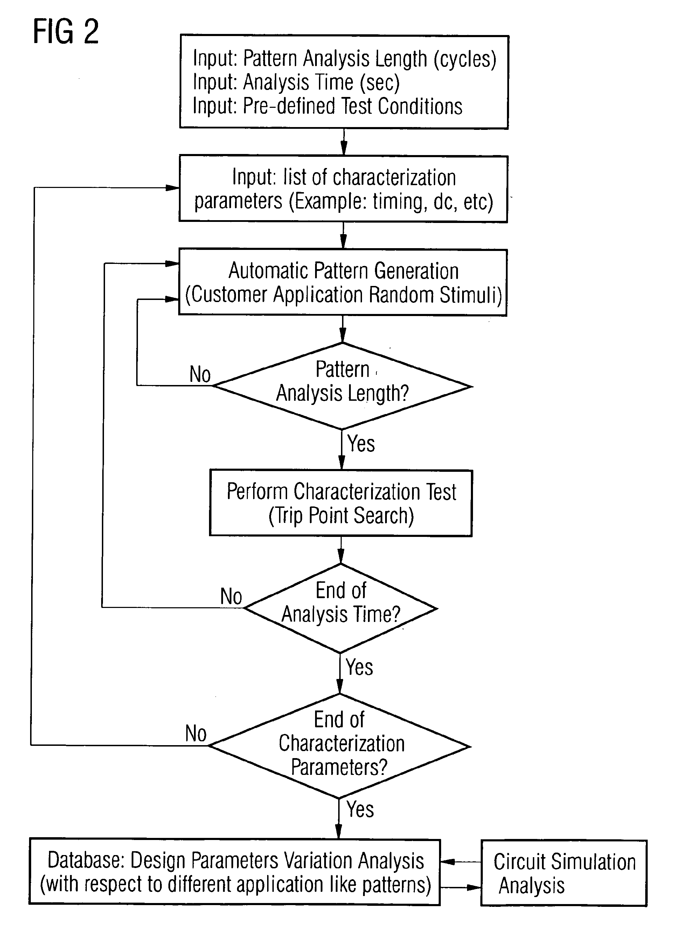

Referring now to Fig. 2. There is shown a first embodiment of the invention useful to analyze design parameter variation with respect to application like access with pre defined application test condition and large run time.

Pre defined data are characteristic read data valid time parameter, e.g.:
Pre defined test condition: 2 core power supply level is 1,8 V (norm) and 1,9 V (high). TRC (device row cycle time) is 85 ns (refer to customer/application spec.). Trip point search from 100 ns to 7 ns and the analysis time is 30 min.
The design characterization analysis steps are characterized as following:
   1. Define pattern analysis length (number of cycles), analysis time, pre-defined characterization (customer) test condition.
   2. Define number of characterization design parameters in a list.
   3. Automatic (e.g. random) test pattern generation using ATE (Automatic Test Equipment) or any signal generator and measurement system.
   4. Repeating step 3 until the pattern analysis length (e.g. trip point search at every 1000 cycles).
   5. Applying test pattern with pre-defined characterization test condition to a device under test (DUT).
   6. Start characterization test (trip point search) and stored trip point with respect to input pattern.
   7. Repeating step 3 to 6 until end of analysis time.
   8. Repeating step 2 to 7 until end of characterization parameters in the list.
   9. Stop characterization of parameter variation analysis.
   10. Analyze design parameters variation with minimum and maximum trip point patterns and analyze them using ATE (including wafer probing internal signals) and circuit simulation. Variation too large imply potential reduction problem and robustness of the design is weak. It is likely out of specification in real application test. Otherwise, the design parameters are in specification.

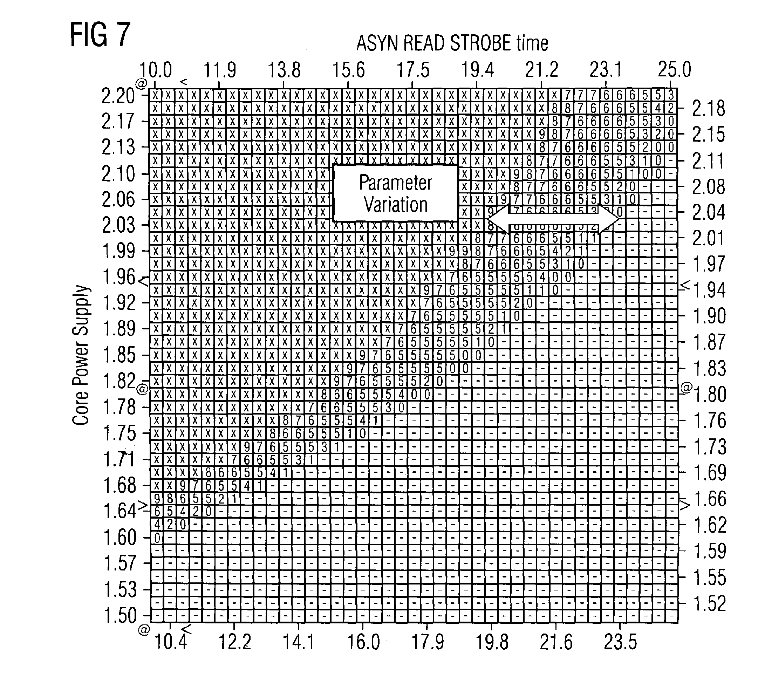

Fig. 7 demonstrates the result 1 also demonstrated that the excellent overview of design parameter variation range and each range value is corresponding to the dedicated pattern sequence, which can used to localize the design weakness. Notice at Vdd 2,0 V (Y-axis) shown much wider range of variation, one reason can be explain is that the chip tend to run faster at high Vdd, but shall also work at 2,2 V. Such large variation indicates potential design weaknesses and production yield issues.

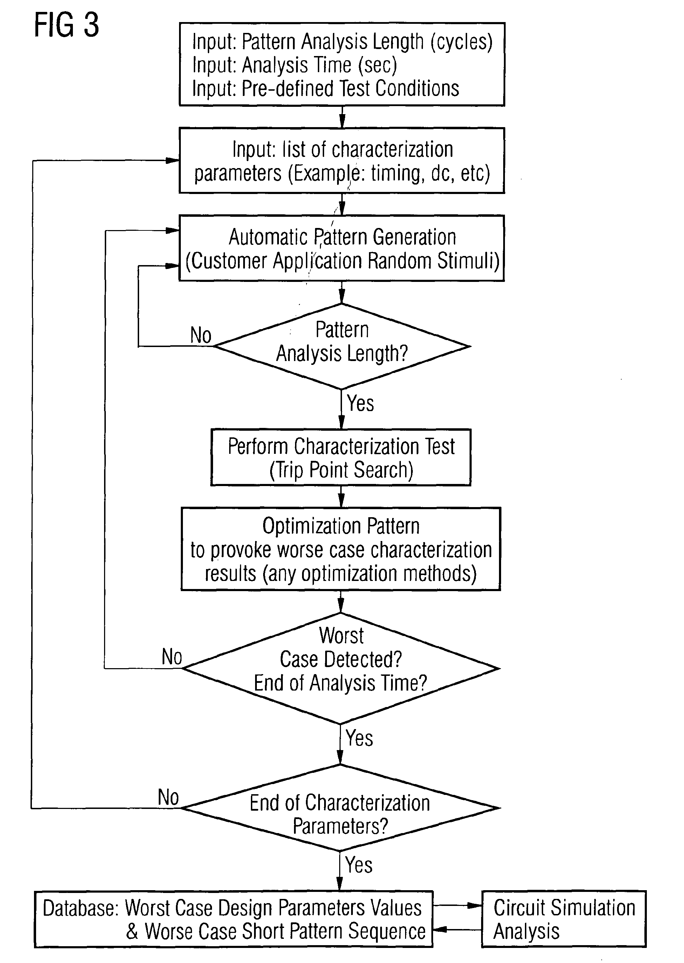

Referring now to Fig. 3. There is shown a second embodiment of the invention useful to analyze worst case parameter value with respect to worst case application like access (optimization) with pre-defined application test condition.

Characterize read data valid time parameter are e.g.

Pre defined test condition: 2 core power supply level of 1,8 V (norm) and 1,9 V (high).

The TRC is 85 ns (refer to customer/application spec.). The trip point search vries from 100 ns to 7 ns and the analysis time is 30 min.

The steps are characterized as following:
1. Define pattern analysis length (number of cycles), analysis time, pre-defined characterization (customer) test condition.
2. Define number of characterization design parameters in a list.
3. Automatic (e.g. random) test pattern generation using ATE or any signal generator and measurement system.
4. Repeating step 3 until the pattern analysis length (e.g. trip point search at every 1000 cycles).
5. Applying test pattern with pre-defined characterization test condition to a device under test (DUT).
6. Start characterization test (trip point search) and stored trip point with respect to input pattern.
7. Start trip point optimization with respect to input test pattern (any optimization methods).
8. Repeating step 3 to 7 until worst case is detected or end of analysis time.
9. Repeating step 3 to 8 until end of characterization parameters in the list.
10. Stop characterization of worst case parameter analysis.
11. Analyze and check if worst case trio point is out of specifications.
12. From step 10, extract the worst case pattern if trip point out of marginal of specification using ATE (including wafer probing internal signals) and circuit simulation. This approach ensures that worst case characterization is performed.

The worst case pattern sequence can provoke the worst case characterization result. Without optimization, worst case can not be detected easily. Typical characterization method (prior art) can never detect such a fault.

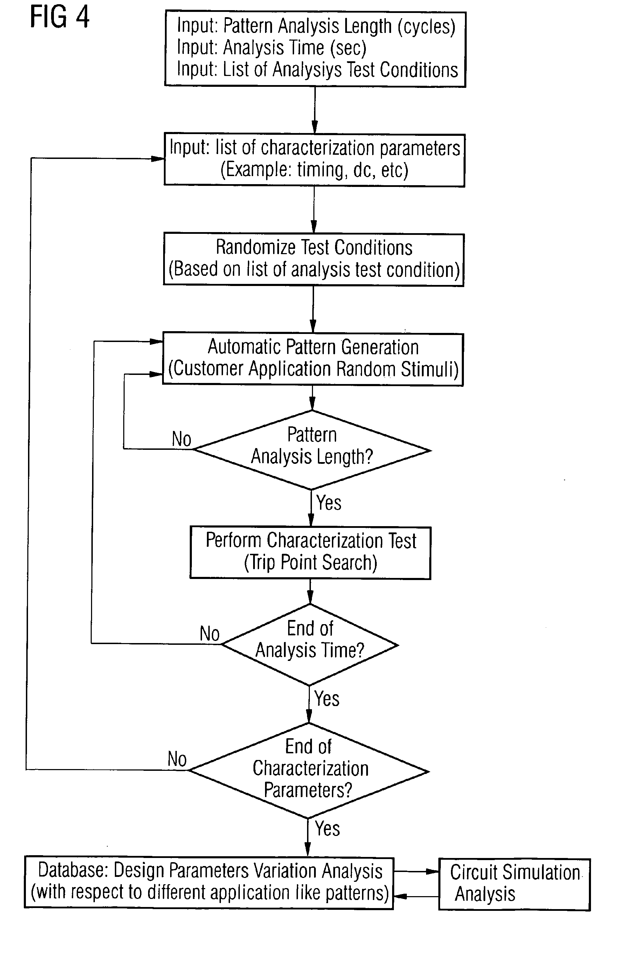

Referring now to Fig. 4. There is shown a third embodiment of the invention useful to analyze design parameter variation with respect to application like access with test condition variation impact and large run time.

The steps are characterized as following:
1. Defined pattern analysis length (number of cycles), analysis time, list of analysis (customer) test condition.
2. Defined number of characterization design parameters.
3. Randomize test condition based on the list of analysis test condition and their maximum and minimum specification.
4. Automatic (e.g. random) test pattern generation using ATE or any signal generator and measurement system.
5. Repeating step 4 until the pattern analysis length is reached (e.g. trip point search at every 1000 cycles).
6. Applying test pattern with random test condition variation to a device under test.
7. Start characterization test (trip point search) and stored trip point with respect to input pattern and test variation set.
8. Repeating step 3 to 7 until end of analysis time.
9. Repeating step 2 to 8 until end of characterization parameters in the list.
10. Stop characterization of parameter variation analysis.
11. Analyze design parameters variation with minimum and maximum trip point.
12. From step 11, if variation (maximum-minimum) is too large, extract the minimum and maximum trip point patterns and test condition variation set and analyze them using ATE (including wafer probing internal signals) and circuit simulation. Variation too large imply potential production problem and robustness of design is weak. It is likely out of specification in real application test. Otherwise, the design parameters are in specification.

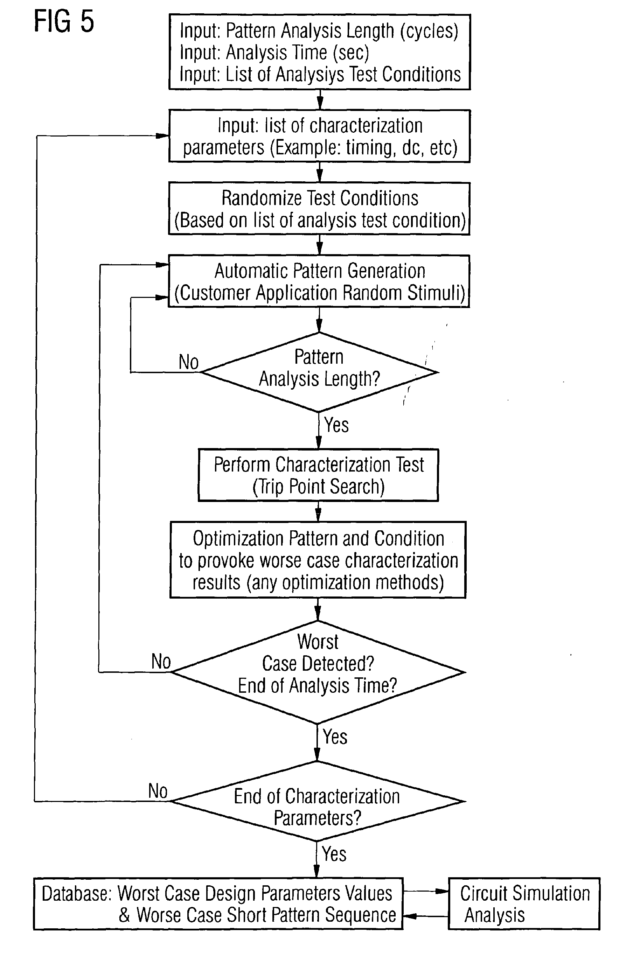

Referring now to Fig. 5. There is shown a fourth embodiment of the invention useful to analyze worse case parameter value with respect to worst case application like access (optimization) with test condition variation impact.
1. Defined pattern analysis length (number of cycles), analysis time, list of analysis (customer) test condition.
2. Defined number of characterization design parameters.
3. Randomize test condition based on a list of analysis test conditions and their maximum and minimum specification.
4. Automatic (e.g. random) test pattern generation using ATE or any signal generator and measurement system.
5. Repeating step 4 until the pattern analysis length (e.g. trip point search at every 1000 cycles).
6. Applying test pattern with random test condition variation to a device under test.
7. Start characterization test (trip point search) and stored trip point with respect to input pattern and test condition variation set.
8. Start trip point optimization with respect to input test pattern and test condition variation (any optimization methods).
9. Repeating step 3 to 8 until worst case detected or end of analysis.
10. Repeating step 2 to 9 until end of characterization parameters in the list.
11. Stop characterization of worse case parameter analysis.
12. Analyze and check if worst case trip point out of specifications.
13. From 11, extract the worse case pattern and test condition variation set if trip point out of marginal of the specification using ATE (including wafer probing internal signals) and circuit simulation. This approach ensures that the worst case characterization is performed.

It is a great achievement with the help of optimization to detect a pattern sequence and test condition variation set can cause direct failure to the chip. It also means that if customer applies this access sequence and test condition set will cause the whole application failure.

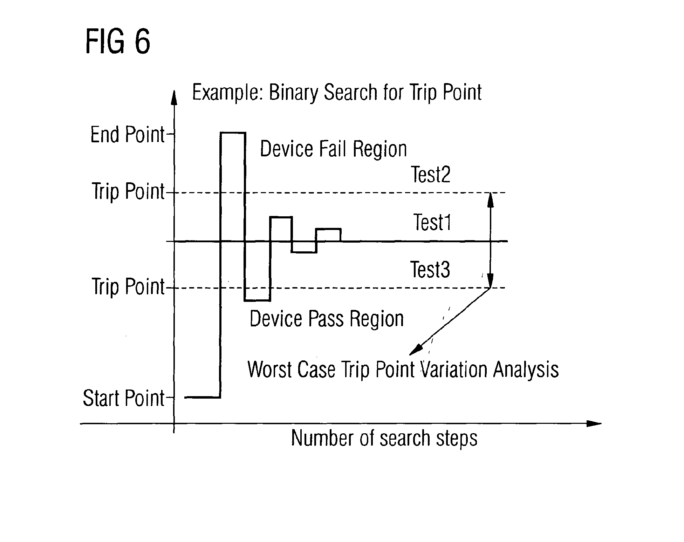

Fig. 6 shows the general scheme of the device characterization concept to test a semiconductor design by multiple trip point characterization concept instead of single trip point concept according the prior art as shown in Fig. 1.Auch as test 1, 2 and 3in Fig. 7 produce different trip point values instead of looking at only one single trip point value (e.g. trip point = 60 ns in Fig.1) refer to one deterministic test.

The multiple trip point is determined by ATE measurement. The worst case multiple point variation analysis is analysis is analyzed by the four methods as described in Fig. 2, 3, 4, 5. The trip point value is determined by ATE measurement.

The test optimization in Fig. 3 and 5 for the worst case trip point variation analysis can based on any optimization and learning-adaptive methods, such as genetic algorithm, linear programming, neural network or fuzzy-expert system.

In the final phase, the detected worst case test can analyze in detail using ATE and simulation methods. At least, the whole process of characterization concept is based on long running analysis methods, comprising defined pattern analysis length, an analysis time, and number of analysis design parameters as a list such that characterization is based on the theory that the design parameters are a function of different customer like pattern and test condition according to an equation like following:
characterize design parameters (randomize/optimize (input pattern, test condition))
by using pattern and condition variation and optimization technique (PCVOT), so that the design parameters are a function of different customer like pattern and test condition so that the range of design parameters variation with respect to the different input pattern or condition or combination of them is analyzed until the worst case is detected.

## Claims

1. Device characterization concept to test a semiconductor design by simulation, comprising storing an defined pattern and defined pattern analysis length, an analysis time and defined number of characterization design parameters as a list in a memory simulating a device under test (DUT), **characteriz-ed by** a multiple trip point characterization concept producing different trip point values determined,
analyzing the worst case multiple point variation,
determining the trip point value,
test optimization for the worst case trip variation analysis,
whereby the design parameters are a function of different customer like pattern and test condition according the equation
characterize design parameters (randomize/optimize (input pattern, test condition))
by using pattern and condition variation and optimization technique (PCVOT), so that the design parameters are a function of different customer like pattern and test condition
and that the range of design parameters variation with respect to the different input pattern or condition or combination of them is analyzed until the worst case is detected.

2. Device characterization concept according claim 2, **characterized in that** for the automatic test pattern generation is used an automatic test equipment (ATE).

3. Device characterization concept according claim 2 and 3, **characterized in that** the trip point search is performed based on short test sequence, such as every 50 to 1000 pattern cycles.

4. Device characterization concept according claim 1, **char-acterized by** the steps:
- using an automatic test pattern generation,
- repeating the test pattern generation until the pattern analysis length, applying test pattern with pre-defined **characterized** test condition to DUT,
- start characterization test (trip point search) and stored trip point with respect to input pattern,
- repeating the steps until the end of analysis time and until the end of the characterization parameters in the list and stop of parameter variation analysis,
- analyze design parameters variation with minimum and maximum trip point and
- if variation (maximum, minimum) is too large, the minimum and maximum trip point patterns are to extract using ATE and circuit simulation.

5. Device characterization concept according claim 1 to 3, **characterized by** the steps:
- using an automatic test pattern generation,
- repeating the test pattern generation until the pattern analysis length, applying test pattern with pre-defined **characterized** test condition to DUT,
- start characterization test (trip point search) and stored trip point with respect to input pattern,
- repeating the steps until the end of analysis time
- repeating the foregoing step until the end of characterization parameters in the list,
- stop characterization of worst case parameter analysis,
- analyze and check if worst case trip point is out of specifications,
- extract the worst case pattern if trip point is out of the marginal of specification using ATE and circuit simulations.

6. Device characterization concept according claim 1 to 3, **characterized by** the steps:
- using an automatic test pattern generation,
- repeating the test pattern generation until the pattern analysis length, applying test pattern with pre-defined
**characterized** test condition to DUT,
- start characterization test (trip point search) and stored trip point with respect to input pattern and test condition variation set,
- repeating the steps until worst case detected or end of analysis time
- repeating the last step and until the end of characterization parameters in the list,
- stop characterization of worst case parameter analysis,
- analyzing design parameters variation with maximum and minimum trip point,
- if variation (maximum-minimum) is too large, extract the minimum and maximum trip point patterns and analyze them using the ATE and circuit simulation.

7. Device characterization concept according claim 1 to 3, **characterized by** the steps:
- using an automatic test pattern generation,
- repeating the test pattern generation until the pattern analysis length, applying test pattern with pre-defined
**characterized** test condition to DUT,
- start characterization test (trip point search) and stored trip point with respect to input pattern and test condition variation set,
- repeating the foregoing steps until the end of analysis time
- repeating the last step until the end of characterization parameters in the list and stop of parameter variation analysis,
- start trip point optimization with respect to input pattern and test condition variation and repeating th foregoing steps until worst case detected or end of analysis time
- repeating the last step until end of the parameters in the list
- stop characterization of worst case parameter analysis
- analyzing and check if worst case trip point is out of specification, and
- extracting the worst case pattern and test condition variation set if trip point is out of marginal of specification using ATE and circuit simulation.

8. Device characterization concept according one of the claim 1 to 7, **characterized in, that** the characterization concept is based on long running analysis methods, comprising defined pattern analysis length, an analysis time and number of analysis design parameter as a list.
